Europäisches Patentamt

European Patent Office

Office européen des brevets

(11) Veröffentlichungsnummer : **0 071 918**
**B1**

(12) **EUROPÄISCHE PATENTSCHRIFT**

(45) Veröffentlichungstag der Patentschrift :
17.10.84

(51) Int. Cl.³ : **H 03 L   7/10**

(21) Anmeldenummer : **82106928.3**

(22) Anmeldetag : **30.07.82**

(54) **Phasengeregelter Oszillator.**

(30) Priorität : **03.08.81 DE 3130711**

(43) Veröffentlichungstag der Anmeldung :
**16.02.83 Patentblatt 83/07**

(45) Bekanntmachung des Hinweises auf die Patenterteilung : **17.10.84 Patentblatt 84/42**

(84) Benannte Vertragsstaaten :
**NL SE**

(56) Entgegenhaltungen :
**DE-A- 2 812 377**
**US-A- 4 336 505**

(73) Patentinhaber : **Siemens Aktiengesellschaft**
**Berlin und München Wittelsbacherplatz 2**
**D-8000 München 2 (DE)**

(72) Erfinder : **Lehmann, Uwe, Dipl.-Ing.**
**Paula-Wimmer-Strasse 17**
**D-8060 Dachau (DE)**

Jouve, 18, rue St-Denis, 75001 Paris, France

## Beschreibung

Die Erfindung bezieht sich auf einen phasengeregelten Oszillator mit einem Phasendiskriminator, einem Schleifenfilter und einem spannungsgesteuerten Oszillator (PLL-Schleife) und mit einer Fangeinrichtung.

Ein derartiger Oszillator ist durch die DE-OS 28 12 377 bekannt. Dabei ist am Ausgang des Schleifenfilters ein Schmitt-Trigger angeschaltet, dessen Ausgang über einen ohmschen Gegenkopplungswiderstand mit dem Verbindungspunkt des ohmschen Widerstandes und des Kondensators des Schleifenfilters verbunden ist.

Bei phasengeregelten Oszillatoren mit Suchoszillatoren, die das Fangen von schmalbandigen PLL-Schleifen in einem breiten Frequenzbereich ermöglichen, kann sich die Suchschwingung bei geschlossener Regelschleife um die Schleifenverstärkung verkleinern oder selbständig abschalten oder von einem Signal abgeschaltet werden, das durch einen zweiten Phasendiskriminator aus der Quadraturkomponente gewonnen wird, wie es beispielsweise bei Schaltungen in dem Buch « Phaselock Techniques » von F.M. Gardner vorgesehen ist.

Bei hohen Vergleichsfrequenzen wird der Schaltungsaufwand für eine Einrastkontrolle mit einem zweiten Phasendiskriminator beachtlich, da an beiden Phasendiskriminatoren definierte Amplituden und Phasenbeziehungen möglichst auch in einem großen Frequenzbereich eingestellt werden müssen.

Auch die Anwendung der üblichen Suchoszillatorschaltungen ist problematisch, da zwei gegensätzliche Anforderungen an die Schaltungsankopplung gestellt werden. Zum einen muß nämlich der Suchhub so groß sein, daß auch bei einem Spannungsoffset des Phasendiskriminators der Oszillator einwandfrei über den gewünschten Bereich gewobbelt wird. Zum anderen aber muß der Suchhub so klein sein, daß bei geschlossener Regelschleife die Wobbelschaltung den Arbeitspunkt des Phasendiskriminators nur wenig verändert. Da der Phasendiskriminatorarbeitspunkt bei PLL-Schaltungen 1. und 2. Ordnung auch ohne Wobbelschaltung durch temperaturabhängige Offsetspannungen des Phasendiskriminators, temperaturabhängige Frequenzschwankungen des Oszillators oder z. B. Änderung der Eingangsfrequenz schon meist großen Schwankungen unterworfen ist, wird die Dimensionierung der oben angeführten Suchoszillatorschaltungen sehr kritisch.

Der Erfindung liegt die Aufgabe zugrunde, für einen phasengeregelten Oszillator eine Lösung anzugeben, durch die die vorstehend genannten Schwierigkeiten in einfacher Weise behoben werden.

Diese Aufgabe wird bei einem phasengeregelten Oszillator der eingangs beschriebenen Art gemäß der Erfindung in der Weise gelöst, daß ein Integrator vorgesehen ist, dessen Ausgangsspannung über einen zwischen Schleifenfilter und spannungsgesteuerten Oszillator eingeschalteten Spannungssummierer in die PLL-Schleife eingekoppelt wird und der zwei von einer Steuerlogik gesteuerte, wechselweise anschaltbare Rückkopplungswege von einem Anschlußpunkt vor und hinter dem Spannungssummierer über jeweils einen Spannungsauswerter zu seinem Eingang aufweist, und daß die Spannungsauswerter aus das Über- oder Unterschreiten von vorgegebenen Spannungswerten digital auswertenden und die Information bis zur folgenden Grenzüberschreitung speichernden Schaltungen bestehen.

Vorteilhafte Ausgestaltungen und Weiterbildungen des Erfindungsgegenstandes sind in den Unteransprüchen angegeben.

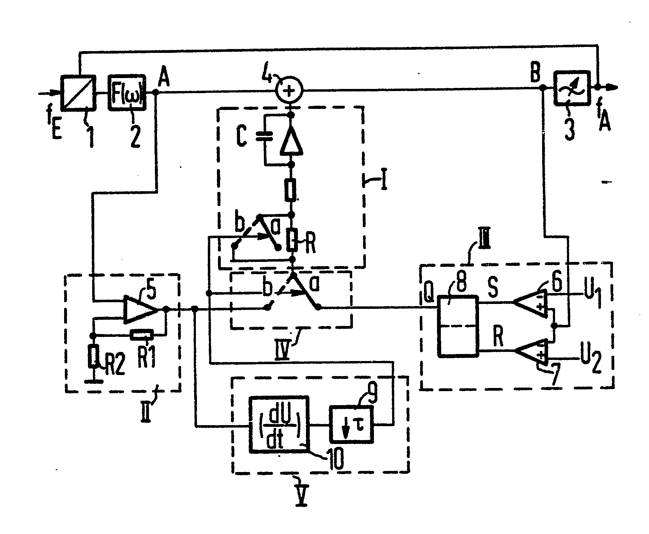

Nachstehend wird die Erfindung anhand eines in der Zeichnung dargestellten Ausführungsbeispiels näher erläutert.

Die konventionelle PLL-Schaltung besteht aus dem Phasendiskriminator 1, dem Schleifenfilter 2 sowie dem spannungsgesteuerten Oszillator (VCO) 3.

In die PLL-Schleife ist zwischen dem Schleifenfilter 2 und dem spannungsgesteuerten Oszillator 3 ein Spannungssummierer 4 eingeschaltet, über den die Ausgangsspannung eines Integrators I (strichliert umrandet) in die PLL-Schleife eingekoppelt wird. Der Integrator I besitzt zwei Rückkopplungswege, die über einen elektronischen Schalter IV (strichliert umrandet) anschaltbar sind und an einen Anschlußpunkt A vor dem Spannungssummierer 4 und einen Anschlußpunkt B hinter dem Spannungssummierer 4 führen. In die beiden Rückkopplungswege ist jeweils ein Spannungsauswerter II bzw. III (strichliert umrandet) eingeschaltet. Der Spannungsauswerter II im Rückkopplungsweg zu dem Anschlußpunkt A vor dem Spannungssummierer 4 besteht aus einem Schmitt-Trigger 5, der über einen Widerstand R1 auf einen Widerstand R2 rückgekoppelt ist und dessen Ausgang mit dem einen Anschluß (strichlierte Schalterstellung b) des elektronischen Schalter IV verbunden ist.

Die im Rückkopplungsweg vom Anschlußpunkt B hinter dem Spannungssummierer 4 liegende Auswerteschaltung III enthält zwei Komparatoren 6, 7, deren zweitem, nicht mit der PLL-Schleife verbundenen Eingang jeweils eine Bezugsspannung $U_1$ bzw. $U_2$ zugeführt wird. Die Ausgänge der Komparatoren 6, 7 sind an ein RS-Flip-Flop 8 angeschlossen, dessen Ausgang Q mit dem einen Anschluß (Schalterstellung a) des elektronischen Schalters IV verbunden ist.

Die Verbindung des Integratoreingangs über den elektronischen Schalter IV mit dem Auswerter III für die Spannung hinter dem Spannungssummierer ermöglicht ein einwandfreies Suchen und die mit dem Spannungsauswerter II vor dem Summierer ein Halten des eingerasteten Zustandes der PLL-Schleife. Der Übergang von einem in den anderen Zustand

wird durch selbständige Umschaltung über eine Steuerlogik V (strichliert umrandet) sichergestellt. Diese Steuerlogik, die in einfacher Weise durch einen monostabilen Multivibrator realisiert werden kann, enthält ein Differenzierglied 10 und ein nachfolgendes Zeitglied 9, das an den elektronischen Schalter IV angeschlossen ist sowie an einen gleichartigen Schalter, der innerhalb des Integrators I zu einem Serienwiderstand R parallelgeschaltet ist.

Die Spannungsauswerter II, III sind Schaltungen, die das Über- oder Unterschreiten von vorgegebenen Spannungsgrenzwerten digital auswerten und die Information bis zur folgenden Grenzwertüberschreitung speichern.

Nachstehend wird die Funktion der Schaltung näher erläutert. Im nicht gefangenen Zustand der PLL-Schleife wird eine Suchschwingung in Sägenzahnform durch Rückkopplung des Integrators I über die beiden Komparatoren 6, 7 das RS Flip-Flop und den elektronischen Schalter IV in Stellung a aufrecht erhalten. Die maximale Ausgangsspannung des Integrators I ist dabei so bemessen, daß für jede mögliche Ausgangsspannung des Schleifenfilters 2 hinter dem Summierpunkt die beiden Grenzspannungen $U_1$ und $U_2$ als Schaltspannungen der Komparatoren 6, 7 erreicht werden. Die Frequenz der Suchschwingung ist dabei so zu wählen, daß sie zum sicheren Einrasten der PLL-Schleife wesentlich kleiner ist als die Schleifenbandbreite.

Nach dem Einrasten der PLL-Schleife bleibt die Spannung hinter dem Summierpunkt konstant, d. h. Änderungen der Integratorspannung werden durch die Änderung der Ausgangsspannung des Schleifenfilters kompensiert. Durch diesen Mitzieheffekt erreicht diese Spannung eine von beiden Schaltspannungen des Schmitt-Triggers 5 und bringt durch diesen Schaltvorgang über die Steuerlogik V den elektronischen Schalter IV in die andere Schaltstellung b. Die Steuerlogik V, z. B. ein monostabiler Multivibrator, wird bei jedem Schaltvorgang des Schmitt-Triggers 5 des Spannungsauswerters II geschaltet (« retriggerbares Monoflop »). Auf diese Weise kann sich eine Sägezahnschwingung über den Schmitt-Trigger 5, den Integrator I und die geschlossene PLL-Schleife aufrechterhalten. Für Überwachungszwecke ist die Verzögerungszeit des Monoflops gerade so zu wählen, daß es durch die Sägezahnschwingung gerade getriggert bleibt (Frequenzüberwachung). Die verbleibende Sägezahnschwingung nach dem Schleifenfilter 2, ein Maß für die Störphasenmodulation, kann durch Wahl einer kleinen Schmitt-Trigger-Hysteresis und zusätzliches Einschalten des durch einen Schalter überbrückbaren Widerstandes R beim Integrator I auf kleine Werte für Amplitude und Frequenz eingestellt werden.

Ein wesentlicher Vorteil der erfindungsgemäßen Schaltung liegt darin, daß der statische Arbeitspunkt des Phasenmodulators nicht mehr von der Ausgangsfrequenz des spannungsgesteuerten Oszillators abhängig ist, sondern nur durch die mit einfachen Maßnahmen konstant zu haltenden Schaltpunkte des Schmitt-Triggers bestimmt wird. Beim Ausfall der PLL-Schleife bringt der Integrator die Spannung hinter dem Summierpunkt bis zu einer der Schaltspannungen $U_1$ oder $U_2$, schaltet dadurch den elektronischen Schalter IV und den Integrator I auf kürzeste Integrierzeit um und startet den zuerst beschriebenen Suchvorgang.

## Ansprüche

1. Phasengeregelter Oszillator mit einem Phasendiskriminator (1), einem Schleifenfilter (2) und einem spannungsgesteuerten Oszillator (3) (PLL-Schleife) und mit einer Fangeinrichtung, dadurch gekennzeichnet, daß ein Integrator (I) vorgesehen ist, dessen Ausgangsspannung über einen zwischen Schleifenfilter (2) und spannungsgesteuerten Oszillator (3) eingeschalteten Spannungssummierer (4) in die PLL-Schleife eingekoppelt wird und der zwei von einer Steuerlogik (V) gesteuerte, wechselweise anschaltbare Rückkopplungswege von einem Anschlußpunkt vor und hinter dem Spannungssummierer (4) über jeweils einen Spannungsauswerter (II, III) zu seinem Eingang aufweist, und daß die Spannungsauswerter (II, III) aus das Über- oder Unterschreiten von vorgegebenen Spannungswerten digital auswertenden und die Information bis zur folgenden Grenzwertüberschreitung speichernden Schaltungen bestehen.

2. Oszillator nach Anspruch 1, dadurch gekennzeichnet, daß der hinter dem Spannungssummierer (4) angeschlossene Spannungsauswerter (III) zum Suchen der Einrastfrequenz zwei Komparatoren (6, 7), deren einem Eingang jeweils eine von zwei Spannungen (U1, U2) mit vorgegebenem Grenzwert zugeführt wird, und ein den Komparatoren nachgeschaltetes RS-Flip-Flop (8) enthält, das ausgangsseitig an den einen Anschluß(a) des Umschalters (IV) angeschlossen ist.

3. Oszillator nach Anspruch 2, dadurch gekennzeichnet, daß die Ausgangsspannung des Integrators (I) so bemessen ist, daß für jede mögliche Ausgangsspannung des Schleifenfilters (2) hinter dem Summierpunkt (4) die beiden Grenzspannungen (U1, U2) als Schaltspannungen der Komperatoren (6, 7) erreicht werden.

4. Oszillator nach einem der Ansprüche 1 bis 3, dadurch gekennzeichnet, daß der vor dem Spannungssummierer (4) angeschlossene Spannungsauswerter (II) zum Halten des eingerasteten Zustandes einen Schmitt-Trigger (5) enthält, dessen Ausgang einerseits mit der Steuerlogik (V) und andererseits mit dem anderen Anschluß (b) des Umschalters (IV) verbunden ist.

5. Oszillator nach einem der Ansprüche 1 bis 4, dadurch gekennzeichnet, daß der Schmitt-Trigger (5) eine kleine Hysterese aufweist.

6. Oszillator nach Anspruch 5, dadurch gekennzeichnet, daß im Integrator (I) ein hochohmiger Widerstand (R) in Reihenschaltung angeordnet ist.

7. Oszillator nach einem der vorhergehenden Ansprüche, dadurch gekennzeichnet, daß die Frequenz der Sägezahnform aufweisenden Suchschwingung wesentlich kleiner ist als die Schleifenbandbreite.

## Claims

1. A phase-controlled oscillator having a phase discriminator (1), a loop filter (2) and a voltage-controlled oscillator (3) (PLL-loop) and having a latching arrangement, characterised in that there is provided an integrator (I) whose output voltage is coupled into the PLL-loop by means of a voltage adder (4) inserted between the loop filter (2) and the voltage-controlled oscillator (3), said integrator having two feedback paths to its input, controlled by a control logic (V) and alternately connected from a connection point in front of the voltage adder (4) and a connection point behind the voltage adder (4), each via a respective voltage analyser (II, III), and that the voltage analysers (II, III) consist of circuits which digitally analyse overshooting or undershooting of predetermined voltage values and store the information until the following overshooting of the limit value.

2. An oscillator as claimed in Claim 1, characterised in that in order to search for the latching frequency the voltage analyser (III) connected behind the voltage adder (4) comprises two comparators (6, 7) each having one input fed with one of two voltages (U1, U2) having a predetermined limit value, and comprises an RS-type flip-flop (8) connected following the comparators and which at the output end is connected to the one terminal (a) of the change-over switch (IV).

3. An oscillator as claimed in Claim 2, characterised in that the output voltage of the integrator (I) is dimensioned to be such that for each possible output voltage of the loop filter (2) behind the adder point (4), the two limit voltages (U1, U2) are obtained as switching voltages of the comparators (6, 7).

4. An oscillator as claimed in one of Claims 1 to 3, characterised in that in order to maintain the locked state the voltage analyser (II) connected in front of the voltage adder (4) comprises a Schmitt-trigger stage (5) whose output is connected to the control logic (V) and to the other terminal (b) of the change-over switch (IV).

5. An oscillator as claimed in one of Claims 1 to 4, characterised in that the Schmitt-trigger stage (5) has a small hysteresis.

6. An oscillator as claimed in Claim 5, characterised in that a high-value resistor (R) is arranged in a series-connection in the integrator (I).

7. An oscillator as claimed in one of the preceding Claims, characterised in that the frequency of the saw-tooth shaped search oscillation is substantially smaller than the loop bandwidth.

## Revendications

1. Oscillateur commandé en phase, avec un discriminateur de phase (1), un filtre en boucle (2) et un oscillateur à commande par la tension (3) (boucle PLL) et avec un dispositif d'interception, caractérisé par le fait qu'il est prévu un intégrateur (I) dont la tension de sortie est couplée dans la boucle (PLL), par l'intermédiaire d'un additionneur de tensions (4) monté entre le filtre en boucle (2) et l'oscillateur à commande par la tension (3), et qui comporte deux voies de contre-réaction, commandées par un circuit logique (V) et susceptibles d'être branchées alternativement entre un point de branchement situé en amont et en aval de l'additionneur de tensions (4) et par l'intermédiaire d'un évaluateur de tensions (II, III), et son entrée, et que les évaluateurs de tensions (II, III) sont constitués par des circuits qui évaluent numériquement le dépassement de valeurs de tensions prédéterminées, vers le haut ou le bas, et qui mémorisent l'information jusqu'au dépassement suivant de la valeur limite.

2. Oscillateur selon la revendication 1, caractérisé par le fait que l'évaluateur de tension (III), qui est branché en aval de l'additionneur de tensions (4) et servant à la recherche de la fréquence de verrouillage, comporte deux comparateurs (6, 7) dont respectivement une entrée reçoit une des deux tensions (U1, U2) à valeur limite prédéterminée, ainsi qu'un multivibrateur bistable RS (8) monté en aval des comparateurs, et qui est, du côté sortie, relié à la borne (a) du commutateur (IV).

3. Oscillateur selon la revendication 2, caractérisé par le fait que la tension de sortie de l'intégrateur (I) a une valeur telle que pour chaque tension de sortie, possible, du filtre en boucle (2), les deux tensions limites (U1, U2) sont obtenues, en aval du point de sommation (4), en tant que tensions de commutation pour les comparateurs (6, 7).

4. Oscillateur selon l'une des revendications 1 à 3, caractérisé par le fait que l'évaluateur de tension (II) qui est branché en amont de l'additionneur de tensions (4) comporte, en vue du maintien de l'état enclenché d'une bascule de Schmittt (5) dont la sortie est reliée d'une part au circuit logique de commande (V) et, d'autre part, à la borne (b) du commutateur (IV).

5. Oscillateur selon l'une des revendications 1 à 4, caractérisé par le fait que la bascule de Schmitt (5) ne présente qu'une faible hystérèse.

6. Oscillateur selon la revendication 5, caractérisé par le fait qu'il est prévu dans l'intégrateur (I) une résistance fortement ohmique (R) en montage série.

7. Oscillateur selon l'une des revendications précédentes, caractérisé par le fait que la fréquence de l'oscillation de recherche qui présente une forme en dents de scie, est nettement inférieure à la largeur de bande de la boucle.